# FASCICULE DE BREVET EUROPEEN

(11) **EP 0 485 312 B1**
(45) Date de publication et mention de la délivrance du brevet: **28.12.1994**
(21) Numéro de dépôt: 91420392.2
(22) Date de dépôt: 05.11.1991
(51) Int. Cl.: H01L 31/024, F25D 19/00

(54) **Procédé pour réaliser l'assemblage réversible d'un circuit électronique de lecture et/ou d'exploitation et d'un support conducteur ou non de l'électricité**
Verfahren zur Herstellung einer übertragbaren Zusammensetzung von einer elektronischen Schaltung für das Lesen und/oder den Betrieb und von einem Leitungsfähigen (oder nicht-)Träger
Process for fabricating the reversible assembling of an electronic circuit for reading and/or exploitation and of an electricity conductive or non-conductive holder

(30) Priorité: 09.11.1990 FR 9014182
(43) Date de publication de la demande: 13.05.1992
(73) Titulaire: SOCIETE FRANCAISE DE DETECTEURS, INFRAROUGES- SOFRADIR, F-92290 Chatenay Malabry (FR)
(72) Inventeur: Montanari, Jean-Louis, F-38320 Herbeys (FR)
(74) Mandataire: Laurent, Michel

(56) Documents cités:
- EP-A- 0 395 487
- WO-A-87/07715
- US-A- 3 993 800
- US-A- 4 479 367

## Description

L'invention concerne un procédé pour réaliser l'assemblage réversible ou démontable d'un circuit électronique de lecture et/ou d'exploitation avec un support conducteur ou non de l'électricité. De manière plus spécifique, l'invention concerne un procédé d'assemblage d'un circuit électronique de lecture et/ou d'exploitation associé à un circuit de détection, avec une enceinte de caractéristiques physiques déterminées notamment en température.

Bien que plus spécifiquement décrite dans le cadre de détecteurs infrarouges, le procédé conforme à l'invention ne saurait se limiter à cette seule réalisation. Toute autre application de ce procédé entre bien entendu dans le champ de protection de cette invention.

Les détecteurs infrarouges fonctionnent traditionnellement à basse température, à savoir dans une gamme de température comprise entre 50 et 130 Kelvins (K). De la sorte, les détecteurs proprement dit sont associés à une enceinte cryostatique (cryostat),dont le doigt froid contient selon leur température d'utilisation de l'azote ou de l'air liquides ou un dispositif cryogénérateur.

Le dispositif de détection proprement dit est fondamentalement constitué d'un premier circuit dit de détection comportant un certain nombre de photosites élaborés collectivement par les techniques de microélectronique sur un matériau semi-conducteur sensible au rayonnement infrarouge. Ce circuit électronique de détection est en échange thermique permanent avec le cryostat, et ce par l'intermédiaire d'un doigt froid.

L'exploitation des rayonnements photoniques détectés par ce circuit s'effectue au niveau d'un circuit de lecture qui lui est associé, ce circuit de lecture étant également en échange thermique permanent avec le cryostat.

Traditionnellement, les connexions entre le circuit de détection et le circuit de lecture et/ou d'exploitation s'effectue soit par des fils de connexion soit par une soudure collective au moyen de microbilles d'indium.

Cette dernière technique, domaine d'application privilégié de l'invention, rend possible l'éclairement des circuits de détection par leur face arrière, évitant de fait l'utilisation de toute connectique encombrante et peu pratique d'utilisation.

L'ensemble constitué du circuit de détection connecté au circuit de lecture et d'exploitation est traditionnellement dénommé "bloc de détection".

Ce bloc de détection, en échange thermique permanent avec le plan froid du cryostat, est maintenu mécaniquement et thermiquement en contact avec celui-ci par l'intermédiaire d'une interface généralement constituée par un support isolant type céramique, la liaison entre ce support et le bloc de détection étant réalisée au moyen d'un joint de colle conductrice, réalisée par exemple en résine époxyde comportant des charges métalliques destinées à assurer la conduction électrique entre la face arrière du bloc de détection et plus précisément du circuit de lecture et d'exploitation et la connectique du cryostat. Celle-ci est généralement constituée de pistes gravées ou sérigraphiées sur le doigt froid. En outre, le support céramique est lui-même fixé sur le plan froid du cryostat au moyen d'un joint de colle isolante électriquement, et typiquement en silicone.

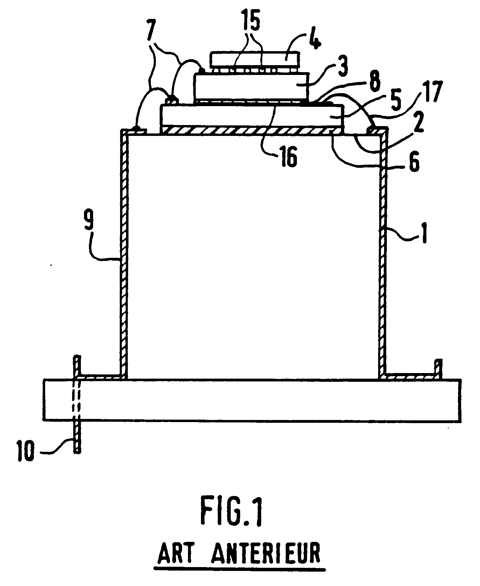

On a par exemple matérialisé sur la figure 1, une représentation schématique d'une telle réalisation, constituant l'art antérieur. Le doigt froid (1) du cryostat, présente à son extrémité supérieure un plan froid (2) destiné à assurer l'échange thermique entre le cryostat proprement dit et le bloc de détection (3,4), correspondant respectivement au circuit de lecture et d'exploitation (3) et au circuit de détection (4). De manière connue, le circuit de détection (4) est connecté électriquement et mécaniquement au circuit de lecture et d'exploitation (3) au moyen de microbilles d'indium (15). Comme on peut le voir sur cette figure 1, on a interposé entre le plan froid (2) et le bloc de détection (3,4) un substrat de connectique (5) réalisé en un matériau isolant typiquement en céramique ou en alumine, sur lequel sont gravés ou sérigraphiés un réseau de pistes conductrices (16). Ce substrat de connectique (5) est généralement fixé sur le plan froid du cryostat (2) au moyen d'un joint de colle (6) isolant électriquement. La connexion électrique entre les pistes gravées ou sérigraphiées (16) du substrat de connectique (5) et des pistes gravées sur et/ou à la périphérie du plan froid (2) est classiquement réalisée au moyen de microfils conducteurs (17).

En outre, les entrées et sorties électriques, notamment en face avant du bloc de détection sont reliées aux pistes conductrices du substrat de connectique au moyen de microfils conducteurs (7) le plus souvent réalisés en or, soudés après collage du bloc de détection sur le substrat de connectique. En outre, une jonction électrique est réalisée entre la face arrière du bloc de détection et plus particulièrement du circuit de lecture d'exploitation (3), notamment métallisé par exemple avec de l'or, et le substrat de connectique (5), et ce au moyen d'une colle conductrice de l'électricité (8).

Enfin, on a représenté par la référence numérique (9) une piste conductrice gravée ou sérigraphiée sur le doigt froid du cryostat (1), aboutissant à un plot de connexion extérieure (10).

Si certes cet agencement, notamment ce contact sur l'intégralité de la face arrière du bloc de détection, présente l'avantage de conférer une excellente homogénéité électrique à cette prise de contact, en revanche ce système ainsi réalisé n'est pas démontable au niveau de l'association substrat de connexion/bloc de détection, de par la nature de la colle conductrice utilisée, et implique en outre une double connectique, d'une part entre le bloc de détection et le substrat de connectique et d'autre part entre ce dernier et les pistes gravées du doigt froid. De fait, cela entraine la réalisation de deux séries de soudures, altérant le rendement de fabrication et donc la productivité, ainsi que la fiabilité résultante de l'ensemble. En outre, l'utilisation d'une colle à base de résine époxyde rend la jonction irréversible sauf à dégrader les constituants qu'elle joint. La démontabilité par voie mécanique est exclue, les forces d'arrachement nécessaires pour détruire le joint de colle étant supérieures à 1.000 kg/cm². La démontabilité par voie chimique impose l'utilisation de produits nocifs et corrosifs vis à vis de constituants (acides, chlorure de méthylène chaud) à durée d'action longue, altérant de manière rédhibitoire les composants du bloc de détection, voire du cryostat.

Enfin, dans de nombreuses applications,la réduction des dimensions du plan froid est nécessaire, notamment en regard de la puissance dissipée et des dimensions du cryostat, ce que ne favorise pas le substrat de connectique décrit ci-dessus.

Or, ces caractères de démontabilité, de simplicité de connectique et de dimensionnement réduit sont activement recherchés par les utilisateurs de tels circuits de détection, compte tenu des prix très élevés des cryostats et autres systèmes spécifiques. De la sorte, et jusqu'à ce jour, lorsqu'un circuit ne fonctionne pas correctement ou lorsque l'on désire modifier quelques unes de ses caractéristiques, il est nécessaire de pourvoir au remplacement total du système sauf à ménager, comme décrit précédemment, un substrat de connectique qui lui peut être fixé de manière réversible sur le plan froid (2) du cryostat.

L'invention vise à pallier ces inconvénients. Elle propose un procédé apte à permettre l'assemblage réversible ou démontable d'un circuit électronique et d'un support conducteur ou non de l'électricité et notamment du doigt froid d'un cryostat.

Ce procédé de réalisation de l'assemblage démontable d'un circuit électronique de lecture et/ou d'exploitation, dont l'une des faces, dite face avant présente entre autres des pistes conductrices, et dont l'autre face, dite face arrière est métallisée, et d'un support conducteur ou non de l'électricité comportant, dans ce dernier cas, des pistes conductrices métallisées, se caractérise :
- en ce que l'on réalise cet assemblage au moyen d'une colle silicone isolante électriquement ;
- et en ce que l'on interpose entre cette couche de colle et la face arrière métallisée du circuit de lecture et d'exploitation une lame conductrice émergeant latéralement de ladite face arrière, disposée au contact de cette face arrière métallisée et reliée à une borne de connexion dudit support, ladite borne étant isolée électriquement si ce dernier est conducteur de l'électricité.

En d'autres termes, l'invention consiste à ne plus faire appel à de la colle époxyde conductrice d'électricité, mais à une colle silicone dont on connait par ailleurs les propriétés de démontabilité, notamment par utilisation de solvants traditionnels peu corrosifs et, de résoudre le problème de complexité de la connectique et de l'encombrement en solidarisant par tout moyen une feuille ou ruban conducteur avec la face arrière métallisée du circuit électronique constituant alors le contact face-arrière, également appelé contact substrat.

Selon une forme particulière de l'invention, le support conducteur ou non de l'électricité, auquel est solidarisé le circuit électronique en question, est constitué par le plan froid du doigt froid d'un cryostat.

Selon une forme avantageuse de l'invention, la lame conductrice est une feuille, un fil ou un ruban d'or ou d'aluminium.

Selon une forme particulière de l'invention, le circuit de lecture et/ou d'exploitation est associé à un détecteur infrarouge, constituant ensemble le bloc de détection relié en contact thermique avec le plan froid d'un cryostat au moyen d'une colle isolante électrique.

La manière dont l'invention peut être réalisée et les avantages qui en découlent ressortiront mieux de l'exemple de réalisation qui suit donné à titre indicatif et non limitatif à l'appui des figures annexées.

Comme déjà dit, la figure 1 représente un schéma simplifié d'un détecteur infrarouge associé au doigt froid d'un cryostat selon l'art antérieur.

La figure 2 est une représentation schématique d'un détecteur infra-rouge fixé sur le doigt froid d'un cryostat conformément à l'invention.

La figure 3 est une vue du dessous du circuit électronique de lecture et/ou d'exploitation conforme à l'invention.

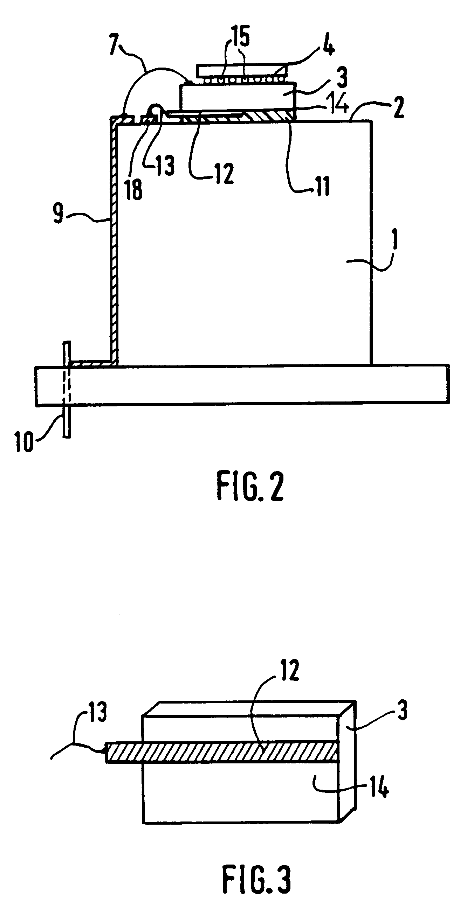

Selon l'invention, et comme on l'a matérialisé sur la figure 2, on procède à l'assemblage du bloc de détection, constitué respectivement du circuit de lecture et d'exploitation (3) associé au circuit de détection proprement dit (4) avec le plan froid (2) du doigt froid (1) d'un cryostat, au moyen d'un joint de colle (11) constituée de silicone. Cette colle n'est pas conductrice de l'électricité. Elle peut être constituée par de la colle commercialisée par RHONE POULENC sous la marque déposée RTV 141. Cette colle silicone présente une résistivité électrique telle qu'elle ne peut absolument pas conduire l'électricité, tout au moins aux tensions utilisées sur ce type de détecteurs.

Corrélativement, la face arrière (14) du circuit électronique de lecture et d'exploitation (3), au niveau de laquelle s'effectue le contact substrat ou contact masse, comporte une feuille d'or ou d'aluminium (12) soudée au niveau de ses sorties ou fixées sur cette face métallisée au moyen d'un point de colle conductrice, par exemple de la colle EPOTEK 417 (marque déposée) commercialisée par EPOTECNY, et constituée par de la colle époxy chargée en particules d'argent . Cette feuille (ou fil) (12) arrive au moins jusqu'au bord latéral du circuit (3) afin de pouvoir être connecté (13) avec une borne de connexion (18), cette dernière étant en liaison électrique avec une piste conductrice du doigt froid du cryostat.

L'utilisation d'une telle colle silicone permet un démontage aisé du bloc de détection hors du doigt froid du cryostat, et plus précisément hors du substrat de connectique. Ce démontage peut être effectué soit par une action mécanique, c'est-à-dire par une action d'arrachement ou cisaillement à l'aide d'une pince brucelle (référencée 5SA et commercialisée par EREM), soit par une action chimique douce telle que l'emploi de trichloréthylène à 80°C pendant quelques minutes, permettant de "ramollir" le joint de colle et de lui faire perdre ses qualités d'adhérence.

De la sorte, lorsque le besoin s'en fait sentir, il devient tout à fait possible de pourvoir au remplacement d'un bloc de détection, sans pour autant nécessiter le remplacement de toute l'installation cryogénératrice. En outre, on peut éviter ainsi de faire appel à un support de connectique, rendant systématiquement plus long, et donc plus couteux la réalisation de tels détecteurs.

Comme déjà dit, ce procédé peut être appliqué à d'autres utilisations, notamment dans le domaine des circuits hybrides dans lesquels on demande fréquemment la démontabilité d'un système tout en assurant un contact électrique entre un composant présentant une face arrière de contact (substrat) et un support récepteur de composants, qui peuvent être constitués de matériaux quelconques.

En conséquence, le collage au moyen de colle silicone permet de fixer directement le bloc de détection sur le plan froid du détecteur compte tenu de son caractère de démontabilité. De la sorte, ce procédé présente l'avantage de réduire l'encombrement des circuits de détection tout en assurant le passage des pistes électriques sous le composant.

## Revendications

1. Procédé de réalisation de l'assemblage démontable d'un circuit électronique de lecture et/ou d'exploitation (3), dont l'une des faces, dite face avant présente entre autres des pistes conductrices, et dont l'autre face, dite face arrière (14) est métallisée, et d'un support conducteur ou non de l'électricité (2) comportant, dans ce dernier cas des pistes conductrices métallisées, **caracterisé** :
- en ce que l'on réalise cet assemblage au moyen d'une colle silicone isolante électriquement (11) ;
- et en ce que l'on interpose entre cette couche de colle (11) et la face arrière métallisée (14) du circuit (3) une lame conductrice (12) émergeant latéralement de ladite face, disposée au contact de cette face arrière métallisée et reliée à une borne de connexion (18) dudit support (2), ladite borne (18) étant isolée électriquement si ce dernier est conducteur de l'électricité.

2. Procédé selon la revendication 1, caractérisé en ce que le support conducteur ou non de l'électricité (2), auquel est solidarisé le circuit électronique de lecture et/ou d'exploitation, est constitué par le plan froid (2) du doigt froid (1) d'un cryostat.

3. Procédé selon l'une des revendications 1 et 2, caractérisé en ce que la lame conductrice (12) est une feuille, un fil ou un ruban d'or ou d'aluminium.

4. Procédé selon l'une des revendications 1 à 3, caractérisé en ce que le circuit de lecture et/ou d'exploitation (3) est associé à un détecteur infrarouge (4) comportant une pluralité de photosites, disposé sur la face avant dudit circuit (3) et constituant avec celui-ci un bloc de détection et est relié en contact thermique avec le plan froid (2) d'un cryostat formant ledit support au moyen de ladite colle silicone isolante électriquement (11).

## Patentansprüche

1. Verfahren zur Durchführung des demontierbaren Zusammenfügens einer elektronischen Lese- und/oder Auswerteschaltung (3), von der eine der Seiten, Vorderseite genannt, unter anderem Leiterbahnen aufweist und von der die andere Seite, Rückseite (14) genannt, metallbeschichtet ist, und eines elektrisch leitenden oder nichtleitenden Trägers (2), der im letzteren Fall metallisierte Leiterbahnen aufweist, dadurch gekennzeichnet,
- daß das Zusammenfügen mittels eines elektrisch isolierenden Silikonklebstoffs (11) durchgeführt wird
- und daß zwischen dieser Klebstoffschicht (11) und der metallbeschichteten Rückseite (14) der Schaltung (3) ein leitfähiger Streifen (12) eingefügt wird, der seitlich über die genannte Seite heraussteht, im Kontakt mit dieser metallbeschichteten Rückseite angeordnet und mit einer Anschlußklemme (18) des genannten Trägers (2) verbunden ist, wobei die genannte Klemme (18) elektrisch isoliert ist, wenn der Träger elektrisch leitend ist.

2. Verfahren nach Anspruch 1, dadurch gekennzeichnet, daß der elektrisch leitende oder nichtleitende Träger (2), an dem die elektronische Lese- und/oder Auswerteschaltung befestigt ist, von der Kühlfläche (2) des Kühlfingers (1) eines Kryostats gebildet wird.

3. Verfahren nach einem der Ansprüche 1 und 2, dadurch gekennzeichnet, daß der leitfähige Streifen (12) eine Folie, ein Draht oder ein Band aus Gold oder Aluminium ist.

4. Verfahren nach einem der Ansprüche 1 bis 3, dadurch gekennzeichnet, daß die Lese- und/oder Auswerteschaltung (3) mit einem Infrarotdetektor (4) verbunden ist, der eine Mehrzahl von Photoerfassungspunkten aufweist, an der Vorderseite der genannten Schaltung (3) angeordnet ist und mit ihr eine Detektor-Baugruppe bildet, und daß sie mittels des genannten, elektrisch isolierenden Silikonklebstoffs (11) in thermischem Kontakt an der den genannten Träger bildenden Kühlfläche (2) des Kryostats befestigt ist.

## Claims

1. Process for producing the removable assembly of an electronic read and/or operating circuit (3), one of the faces of which, termed the front face, has, inter alia, conductive tracks and the other face of which, termed rear face (14), is metallised, and of an electrically conductive or nonconductive support (2) comprising, in the latter case, metallised conductive tracks, characterised :
- in that this assembly is produced using an electrically insulating silicone adhesive (11);
- and in that a conductive foil (12) emerging laterally from the said rear face, arranged in contact with said metallised rear face and connected to a terminal (18) of the said support (2), the said terminal (18) being electrically insulated if said support is electrically conductive, is interposed between said adhesive layer (11) and the metallised rear face (14) of the circuit (3).

2. Process according to Claim 1, characterised in that the electrically conductive or nonconductive support (2), with which the electronic read and/or operating circuit is integrated, comprises the cold plane (2) of the cold finger (1) of a cryostat.

3. Process according to either of Claims 1 and 2, characterised in that the conductive foil (12) is a sheet, a wire or a strip of gold or aluminium.

4. Process according to one of Claims 1 to 3, characterised in that the read and/or operating circuit (3) is combined with an infrared detector (4) comprising a plurality of photosites disposed on the front face of said circuit (3), and constituting with said circuit the detection block, and is joined in thermal contact with the cold plane (2) of a cryostat forming said support by means of said electrically insulating adhesive (11).
